# EUROPEAN PATENT APPLICATION

(11) **EP 2 075 478 A1**
(43) Date of publication of application: **01.07.2009**
(21) Application number: 07025251.5
(22) Date of filing: 31.12.2007
(51) Int. Cl.: F16B 39/286

(54) **Lock nut with a slit**

(71) Applicant: Eco World Company, Limited, Hiroshima-shi Hiroshima 733-0003 (JP)
(72) Inventor: Migita, Hiroaki, Hiroshima-shi Hiroshima (JP)
(74) Representative: Kirschner, Klaus Dieter

(57) **Abstract**

A nut provided with a fastening structure in a nut body (1) including a female screw (2) dug concentrically along a vertical centre axis (L2) wherein an elongated slit (3) is formed above a horizontal centre axis (L1) of the nut body (1) and from one side thereof to a position beyond a vertical centre axis (L2) of the female screw (2) toward the direction of the other side.

## Description

The present invention relates to a nut apparatus having a fastening structure bringing about no looseness even if excessive vibration is applied, for example.

Fastening means with bolts and nuts being one of binding methods used at an occasion of assembling structure such as automobiles, various kinds of machines, electrical appliances and various kinds of architecture is being widely used because of their simplicity in mounting and removal and inexpensive prices. However, when dynamic external force such as impact and vibration or thermal load acting on a fastening body such as bolts, nuts frequently start return rotation. A bolt fastening body loses fastening force and the fastening part will no longer fulfill its function.

Consequently, still in the industrial field even in the recent years, a lot of accidents originated in looseness of bolts and nuts occur. Thus, the problem of looseness of a fastening body with bolts and nuts is one of important issues to be solved in the technological fields.

However, conventionally, a large quantity of bolts and nuts to be screwed thereon is used in respective kinds of appliances and all other structure. Those nuts are fastened tightly and thereby attached firmly and therefore bring out excellent interaction effects as a fastening tool. However, for use in the site where vibration in particular is applied, for example, the nuts are disadvantageous in getting loose due to the vibration.

In order to eliminate such a disadvantage, there is a method of stacking two nuts to use them as a so-called double nut. Employment of such a double nut gives rise to an effect that use in a site where vibration is applied hardly get loose compared with the case where a conventional single nut is used.

However, use as a double nut means that two nuts are used. Therefore, compared with the case of a single nut, costs increase and installation gets twice as troublesome as the single nut is.

In view of those problems, as a result of continued persistent inventive research, the inventors hereof have developed nuts which are single nuts and nevertheless hardly get loose even if vibration is applied thereto and could provide an inclined screw provided with new fastening structure as one of means for solving the problem on that looseness of the fastening body of bolts.

Thus, the inclined screw nut of the present invention is a single type having a shape equivalent to a normal hexagonal nut and nevertheless fastening means of a bolt and a nut requiring no complicated tools and procedures at an occasion of fastening a bolt thereto. Consequently even if vibration is applied, no looseness takes place and a nut apparatus excellent in productivity is provided.

In addition, that nut main body provides structure of preventing looseness at an occasion of fastening a bolt to a nut main body and an apparatus of a nut provided with a mechanism for preventing drop.

Accordingly, a typical feature of a nut apparatus provided with fastening structure of the present invention is in a nut main body having a female screw dug concentrically along a vertical centre axis and an elongated slit is formed above the horizontal centre axis of the nut main body and from one side thereof to a position beyond the vertical centre axis of the above described female screw toward the direction of the other side.

In addition, the bottom of the above described nut body is an inclined plane making an inclined angle of around 1 to 5° against the horizontal plane.

Moreover, height H of the above described nut body in that case establishes relation of H×0.8=H1 compared with height H1 of a normal nut currently on the market.

Embodiments of the invention are now described with reference to the drawings.
FIG. 1 is a plan view of a nut body;
FIG. 2 is a front view of a nut body;
FIG. 3 is a perspective diagram having a nut body undergone elastic-plastic fastening modeling by a rotation angle method;
FIG. 4 is a graph theoretically analyzed relation between the rotation angle and fastening torque of a nut body;
FIG. 5 is a graph depicting relation between rotation axis and fastening torque of a nut body and a JIS standard nut;
FIG. 6 is a graph depicting an analysis result on influence of axial force of a bolt to fastening torque;
FIG. 7 is a graph depicting an analysis result of a JIS standard nut and a nut body with slits;
FIG. 8 is a graph depicting an analysis result on a JIS standard nut and a nut body with an inclined face;
FIG. 9 is a graph depicting an analysis result on a nut body and a JIS standard nut;
FIG. 10 is a graph depicting an analysis result on four types of models of a nut body, a JIS standard nut, a nut body with an inclined plane and a nut body with an elongated slit;
FIG. 11 is a graph depicting an analysis result on four types of models of a nut body, a JIS standard nut, a nut body with an inclined plane and a nut body with an elongated slit at the time of starting fastening the nut body;
FIG. 12 is a graph depicting an analysis result on relation between axial force and fastening torque;
FIG. 13 is a graph depicting the amount of displacement in width in the elongated slit for a bolt axial centre and the nut body;

Table 1 details outer diameter measurements of a nut body;

Table 2 details analytical specifications; and

Table 3 details analytical conditions.

### Embodiment

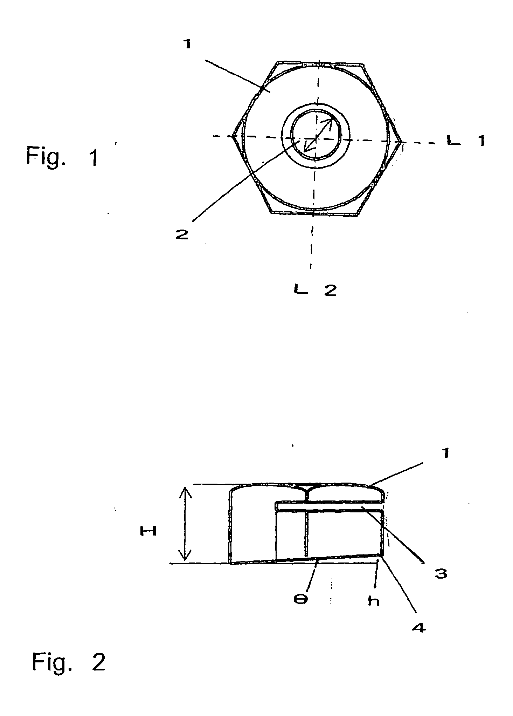

FIG. 1 illustrates an embodiment of a completed nut body 1 of the present invention and includes a female screw 2 bored concentrically about a vertical centre axis L2. And an elongated slit 3 is formed above the horizontal centre axis L1 of that nut body 1 and to such a position of passing by the vertical centre axis L2 of the female screw 2 from one side toward the other side.

And the bottom of the nut body 1 makes an inclined plane 4 having an inclined angle θ of 1° to 5° with respect to the horizontal plane.

Moreover, this embodiment is important in that height H of the nut body 1 and height H1 of a normal nut (not illustrated in the drawing) on the market establishes relation of H×0.8=H1.

In addition, for relation between the height h of the elongated slit 3 of the nut body 1 and the height L of an external plane made by an inclined angle θ of the bottom plane, in order to secure strength of a nut stipulated in Japanese Industrial Standards (JIS) B1052, [h=H-H1-L] or lower is of paramount importance.

Moreover, the width of the elongated slit 3 has to be not shorter than the width of the elongated slit 3. Consequently, [0.5<h<H-H1-L] is derived to establish [h=0.5×(H-H1-L)] (The number 0.5 is a number in consideration of allowable error in measurement)

Next, the height h of the elongated slit 3 is drawn on from that result with the following nut body 1,

| ϕ | H | h | |
|---|---|---|---|
| 16 | 16 | 1.2 | |
| 20 | 20 | 1.5 | |
| 24 | 24 | 1.5 | |
| 30 | 30 | 2.2 | ϕ.....nominal diameter M of nut body 1 |

In the case of M16
h=0.5×(H-H1-L)=0.5×(18-13-0.63=1.2 actual measurement 1.2

In the case of M20
h=0.5×(20-18-0.79)=1.8 actual measurement 1.5

In the case of M24,
h=0.5×(24-19-1.25)=1.8 actual measurement 1.5

In the case of M30,
h=0.5×(30-24-1.61=2.2 actual measurement 2.2. (Measurement table: unit mm)

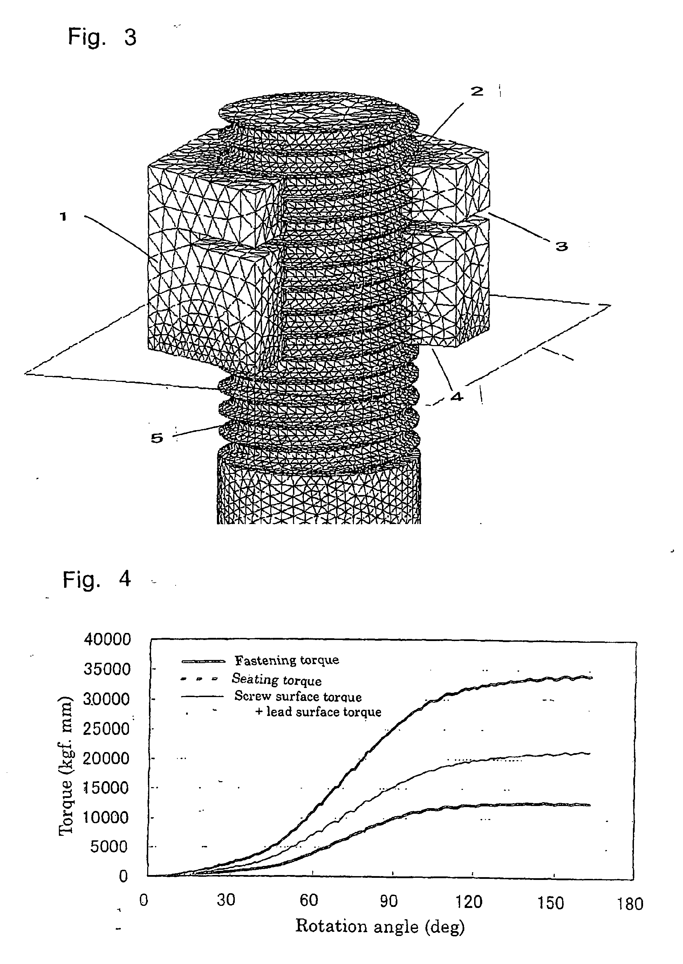

Naturally, the nut body 1 of the present invention is a binding method used at an occasion of assembling a machine and a structure and is used being screwed with the bolt 5, as in FIG. 3. That type of bolt fastening means is being widely used because of their simplicity in mounting and removal and inexpensive prices. However, when dynamic external force such as impact and vibration or thermal load acts on the nut body 1 and the bolt 5, the nut body 1 frequently starts return rotation. The fastening body with that nut body 1 and the bolt 5 loses a fastening force and might no longer perform its function.

Subsequently, Table 1 lists outer diameter measurement of the nut body 1. Nominal diameter of the screws represents measurement of each part from M10 to M42. The slit width is 0.8 mm with M10, 1.0 mm with M12, 1.2 mm with M16 and M20, 1.5 mm with M24 and 2.0 mm with M30. And the nut body 1 generates large contact force in a mating screw part with the seating surface angle and deform of the slit to give rise to looseness prevention effects. In order to provide a clear indicator at an occasion of selecting the nut body 1 as a looseness eliminating screw part, it is necessary to clarify its mechanism and assess effects to strength and kinetic properties.

**Table 1**

| d | A | B | D | G | H | I | E | K | P | W |
|---|---|---|---|---|---|---|---|---|---|---|
| M10 | 19,6 | 17,0 | 10,0 | 0,8 | 5,7 | 13,1 | 9,7 | 3,2 | 1,5 | 12,6 |
| M12 | 21,9 | 19,0 | 12,0 | 1,0 | 7,5 | 14,6 | 11,7 | 3,2 | 1,75 | 17,8 |
| M16 | 27,7 | 24,0 | 16,0 | 1,2 | 10,0 | 18,7 | 23,6 | 4,4 | 2 | 36,0 |
| M20 | 34,6 | 30,0 | 20,0 | 1,2 | 12,5 | 23,6 | 19,5 | 5,8 | 2,5 | 72,0 |
| M24 | 41,6 | 36,0 | 24,0 | 1,5 | 15,0 | 28,5 | 23,4 | 6,9 | 3 | 124 |
| M30 | 53,1 | 46,0 | 30,0 | 2,0 | 18,7 | 36,3 | 29,2 | 8,3 | 3,5 | 258 |
| M36 | 63,5 | 55,0 | 36,0 | 2,0 | 22,4 | 43,4 | 35,0 | 10,4 | 4 | 438 |
| M42 | 75,0 | 65,0 | 42,0 | 2,0 | 26,2 | 51,3 | 40,9 | 12,2 | 4,5 | 723 |

| | | | | | | | | | | |
|---|---|---|---|---|---|---|---|---|---|---|
| The abbreviation words on the top stand for the following; D: nominal diameter of screw A: diagonal dimension (mm) B: distance between parallel surfaces (mm) D: nut height (mm) G: slit width (mm) H: height from nut seating surface to slit (mm) I: depth of slit part (mm) E: nut height on slit side (mm) K: length from slit to nut upper surface P: pitch (mm) and W: weight (gram) | | | | | | | | | | |

In the present invention, applying three-dimensional finite element method, performance of a bolt fastening body with the nut body 1 was assessed descriptively. As performance for assessment, relation between fastening torque and axial force being indispensable for torque management at the time of fastening and strength of respective parts of screws were analyzed.

A tensile strength test, a fatigue test, a vibration test and the like, which are normally carried out, are also carried out in separate researches to check analysis result and actually measured results to verify validity on the analysis result.

In particular, mechanism of looseness prevention function of the nut body 1 and influence of the reduced portion of a screw thread to be cut out at manufacturing over mechanical strength was reviewed.

Subsequently, for analyzing looseness prevention mechanism of the nut body 1 with three-dimensional finite element method with likewise technique, ADINA 8.0 was used as analysis software. Analysis was carried out by modeling elastic-plastic fastening by a nut rotation angle method as in FIG. 3. The analysis was carried out on four types of JIS standard nut, inclined angle θ of the seating surface of the nut body 1 and the one with an elongated slit 3 besides the nut body 1 to review how the inclined angle θ of the bottom plane, the elongated slit 3 and the like affect the screw property.

Assuming that the bolt has a loose screw part with five threads, the grip length is 80 mm and an object to be fastened is a steel body, the bolt bottom plane and the object to be fastened are firmly fixed. Screw dimension includes 6H/6g being nominative diameter M16 in the tolerance zone for a meter coarse thread. A one-dimensional tetrahedral element was used for an element and, for the portions of screw surface contact part and the nut seating surface, fastening torque was analyzed based on accuracy and therefore the element was divided densely.

As a material property value used for that analysis, a vertical elasticity coefficient of a bolt and a nut was set to 200 GPa. In addition, Poisson's ratio of the bolt and the nut was set to 0.3. The strength section of a bolt was set to 10.9 and the nut body 1 was set to 8. Initial yield stress for the bolt 5 was set to 790 MPa. Linear rigid elastic-plastic body was adopted as the plastic side and the tangent modulus for plasticity was set to 2700 MPa for the both of a bolt and a nut.

As for the type for analysis, elastic-plastic analysis in consideration of material non-linearity and geometrical non-linearity is carried out. Frictional coefficient on a contact surface was set to 0.15 and it was assumed that frictional coefficient did not vary during a fastening process.

In that case, analytical conditions will be listed as in Table 2.

**Table 2**

| Specification | Value |
|---|---|
| Screw type | Meter coarse thread |
| Nominal diameter of screw | M16 |
| Screw tolerance | 6H/6g |
| Model element | One dimensional tetrahedral element |
| Contact surface of object to be fastened | Contact element |
| Vertical elastically coefficient of bolt and nut | 200GPa |
| Poisson's ratio of bolt and nut | 0.3 |
| Strength section of bolt | 10.9 |
| Strength section of nut | 8.8 |
| Initial yield stress of bolt | 790MPa |
| Initial yield stress of nut | 790MPa |
| Analysis type | Elastically-plasticity analysis |
| Frictional coefficient on contact surface | 0.15 |

Moreover, system detailed setting was set as shown in Table 3.

**Table3**

| Analysis type | Bolt material | Nut material | Material of object to be fastened | Frictional coefficient µ | w-function | v-function |
|---|---|---|---|---|---|---|
| Dynamic | E=200GPa v=0.3 σ y=790MPa H'=2700MPa | E=200GPa v=0.3 σ y=790MPa H'=2700MPa | Rigid body (E=1e10) | 0.15 | 1 E-10 | 0.05 |

| Bolt screw surface element length | Nut screw surface element length | Nut seating surface element length | Element length of contact surface of object to be fastened | Bolt element length | Nut element length | Element length of object to be fastened |
|---|---|---|---|---|---|---|
| 0.8 | 0.8 | 0.8 | 3 | 3 | 3 | 5 |

| Restrain condition nut | Boundary condition | Repetitious calculation | Hole diameter of object to be fastened | Spring constant | Dumping | Contact offset |
|---|---|---|---|---|---|---|
| Y θ z | Nut fixation | Full Newton n=100 | 0 | 10 | 100 | 0 |

In addition, the node number of a three-dimensional finite element model of HRN is 18014 and element number is 71669. Analysis goes on calculation every 0.1° of the nut rotation angle up to 150°. Calculation result was output every 1°. A computer with Pentium 4, 2.4 Ghz as the CPU is used and calculation time is 40 hours. In addition, the analytical conditions at that time are as listed in Table 3.

Moreover, relation between the rotation angle of the nut body 1 and fastening torque was analyzed theoretically. FIG. 4 graphs the analytical results thereof. In that case, the horizontal axis represents rotation angle of the nut body 1 and the vertical axis represents torque. In the drawing, fastening torque will sum seating surface torque, screw surface torque and lead angle torque. Torque was generated with the HRN at an angle having got around larger than 11°. That is because the seating surface of the nut body 1 is tapered by the inclined plane 4 providing the inclined angle θ.

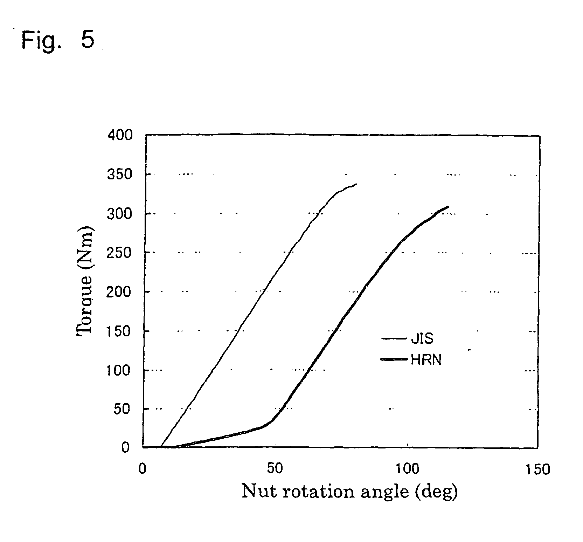

FIG. 5 graphs relation between the nut body rotation angle of the nut body 1 and a JIS standard nut and fastening torque. Thus, in that FIG. 5, the horizontal axis plots the rotation angle (deg) of the nut body 1 and the vertical axis plots fastening torque of the bolt fastening body. The thin line and the solid line respectively represent analytical results of a case with a JIS standard nut and a case with the nut body 1.

Thus, fastening torque of the JIS standard nut has increased uniformly from the nut rotation being around 7°. Fastening torque tends to increase uniformly with the rotation angle up to around 67°. On the other hand, the nut body 1 does not generate fastening torque until the rotation angle gets to around 11°. The reason thereof is that the seating surface of the nut body 1 is provided with an inclined plane of around 1°.

Until the nut body 1 rotates from the rotation angle to get larger than 12° to reach 50°, fastening torque, which is moderate though, was generated. Increasing rate of fastening torque per unit angle for that section is 0.770.

Moreover, when the rotation angle gets to larger than 50°, gradient gets larger suddenly. The reason thereof is that the seating surface of the nut body 1 has reached the rotation angle being 50° and the seating surface of the nut body 1 has seated on an object to be fastened completely.

In addition, comparing the JIS standard nut with the nut body 1, the increase ratio gets smaller around when fastening torque for the JIS standard nut goes larger than 300 Nm. On the other hand, for the nut body 1, the increase ratio gets smaller around when fastening torque gets larger than 250 Nm. Comparing fastening torque at the point where gradient gets smaller, the fastening torque of the nut body 1 is smaller than that of the JIS standard nut by around 50 Nm. The reason thereof is that the nut body 1 is provided with seating surface taper and thereby the bolt is bent while the bolt seats on an object to be fastened to give rise to extension in plasticity with low axial force.

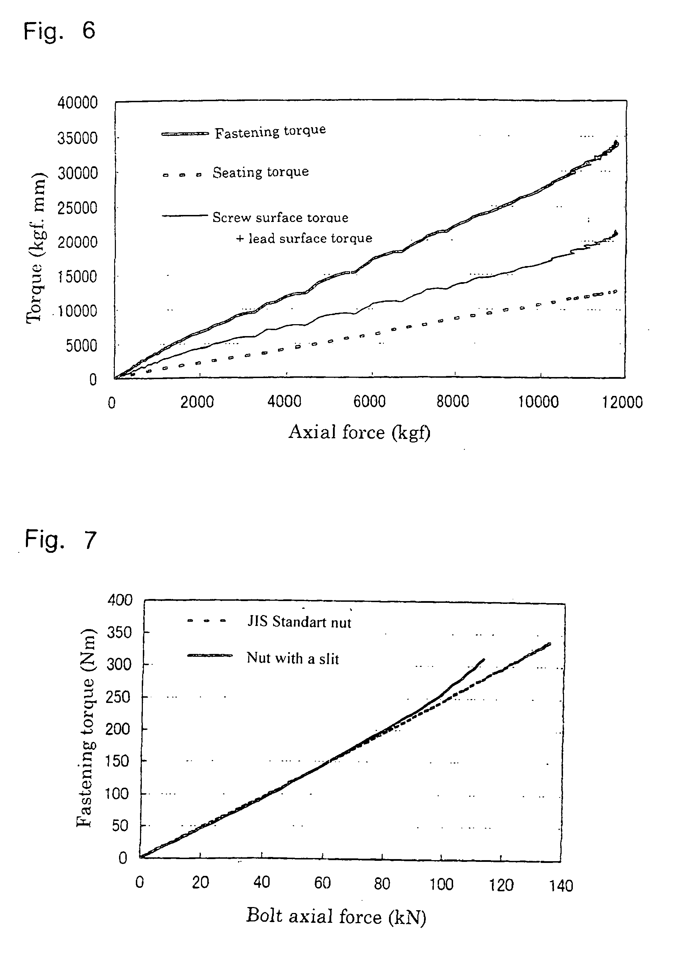

FIG. 6 graphs analytical results of axial force influencing fastening torque and the horizontal axis represents axial force of the bolt body 1 and the vertical axis represents fastening torque.

FIG. 7 to FIG. 10 graph calculation results thereof. The horizontal axis represents axial force of the bolt body 1 and the vertical axis represents fastening torque. And FIG. 7 graphs analytical results on the JIS standard nut and the slit nut body 1. Around when axial force gets larger than 80 kN, fastening torque tends to get larger than fastening torque for the JIS standard nut. When axial force gets larger, influence of slit appears.

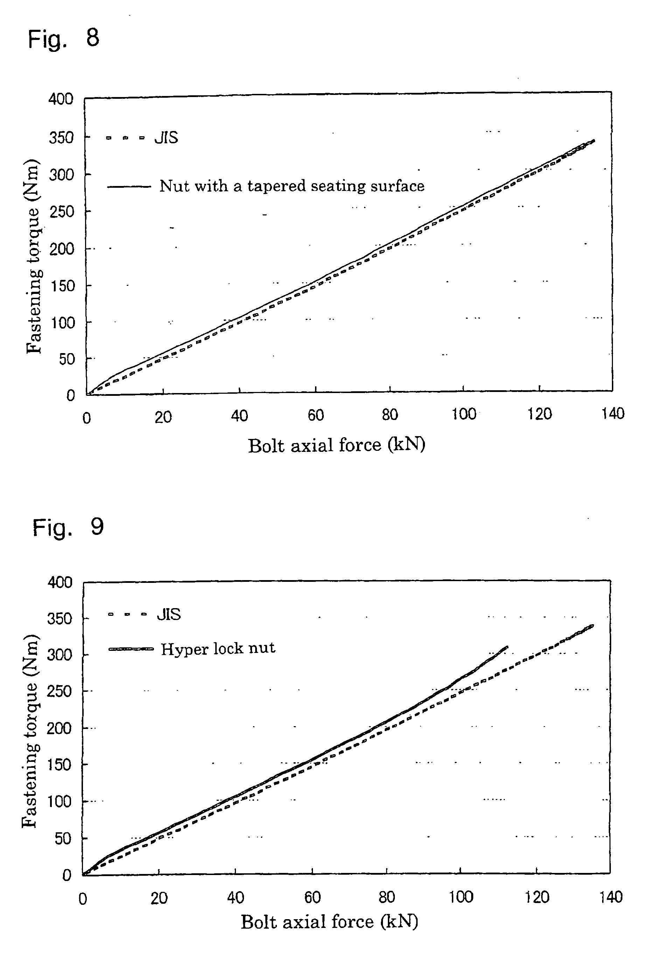

FIG. 8 graphs analytical results on the JIS standard nut and the nut body 1 with an inclined plane 4 with an inclined angle θ. For the inclined angle θ of the nut body 1, that axial force of the bolt 5 shows fastening torque tends to be larger than fastening torque for the JIS standard nut across the entire band.

FIG. 9 graphs analytical results on the nut body 1 and the JIS standard nut. That is, fastening torque for the bolt 5 tends to be larger than fastening torque for the JIS standard nut across the entire band. In particular, for the band with large axial force, fastening torque gets large. It deems that when axial force gets large, an effect of the elongated slit 3 is added further.

For example, with axial force being 60 kN, fastening torque is 157 Nm for the nut body 1 and 147 Nm for the JIS standard nut. In addition, with axial force being 100 kN, fastening torque is 263 Nm for the nut body 1 and 244 Nm for the JIS standard nut. Accordingly, the nut body 1 of the invention hereof is revealed to include a property that fastening torque is larger by around 10 to 20 Nm.

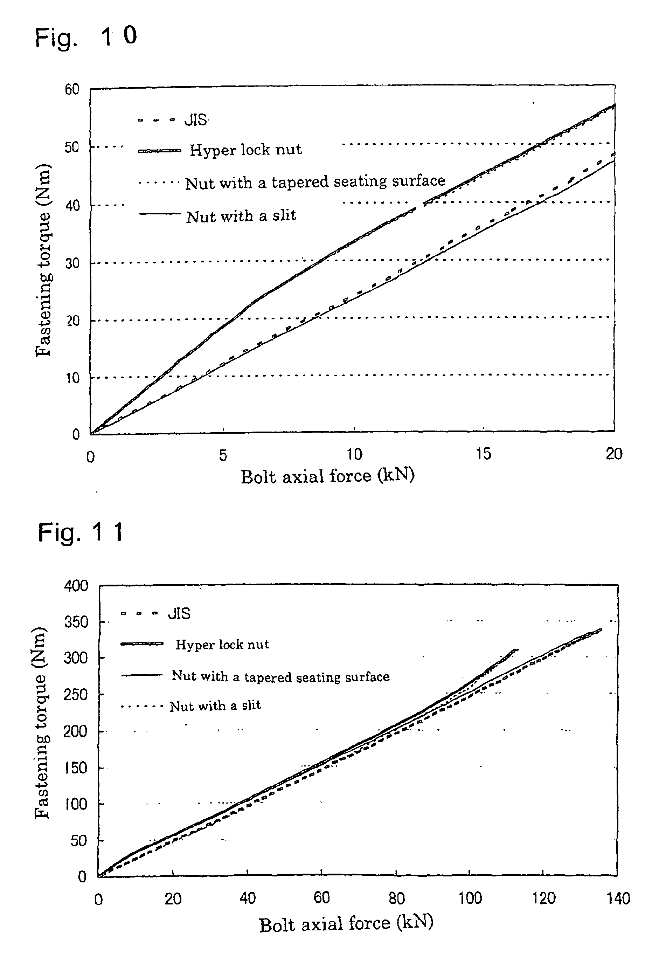

FIG. 10 graphs analytical results on four types of models of the nut body 1, the JIS standard nut, the nut body 1 with an inclined plane 4 [here, models without the elongated slit 3 from the nut body 1 and the nut body 1 with an elongated slit 3 [a model without the inclined plane 4 on the seating surface of the nut body 1]. Here, axial force of the bolt 5 is plotted in detail up to 20 kN. The nut body 1 is revealed to show a property that the fastening effect is larger compared with the JIS standard nut from the beginning to fasten the nut body 1.

FIG. 11 graphs analytical results on four types of models and shows the region from the beginning to fasten the nut body 1 and the end of fastening. The JIS standard nut and the nut body 1 with an inclined plane 4 shows a property that axial force of the bolt 5 has gradient of approximately the same level across the entire band.

On the other hand, the nut body 1 with the inclined plane 4 is larger than the nut body 1 in gradient in the range from the beginning of fastening to fastening torque being 25 Nm. That is common for the model of the seating surface nut body 1 with tapering. The value of gradient matches with the value for the fastening torque being 25 Nm at the time of rotation angle of the former bolt 5 being 40°. Accordingly, this is deemed that the bolt is bent with the seating surface remaining completely seated and energy required for bending is added to energy required for fastening torque of the model lacking the seating surface taper.

In addition, with axial force being not lower than 60 kN, the nut body 1 and the nut body 1 with an elongated slit 3 tends to increase fastening torque gradually. That is a common feature for the model of the nut body 1 with an elongated slit 3. An upper limit is present in axial force derived by analysis based on calculation conditions

That is originated in that mesh in the local portion of a finite element model is significantly deformed and calculation no longer converges. In actual fastening, even if the screw thread of the nut body 1 gets deformed, fastening can be continued. Accordingly, extending the property shown in FIG. 11, generation of further stronger fastening torque can be expected. With the same axial force, larger the fastening torque gets, larger the looseness prevention effect gets.

From the above described analytical results, the nut body 1 with an inclined plane 4, enlargement of fastening torque from the initial period of fastening takes large effect. Enlargement of fastening torque for the elongated slit 3 of the nut body 1 takes effect with the axial force being not lower than 60 kN.

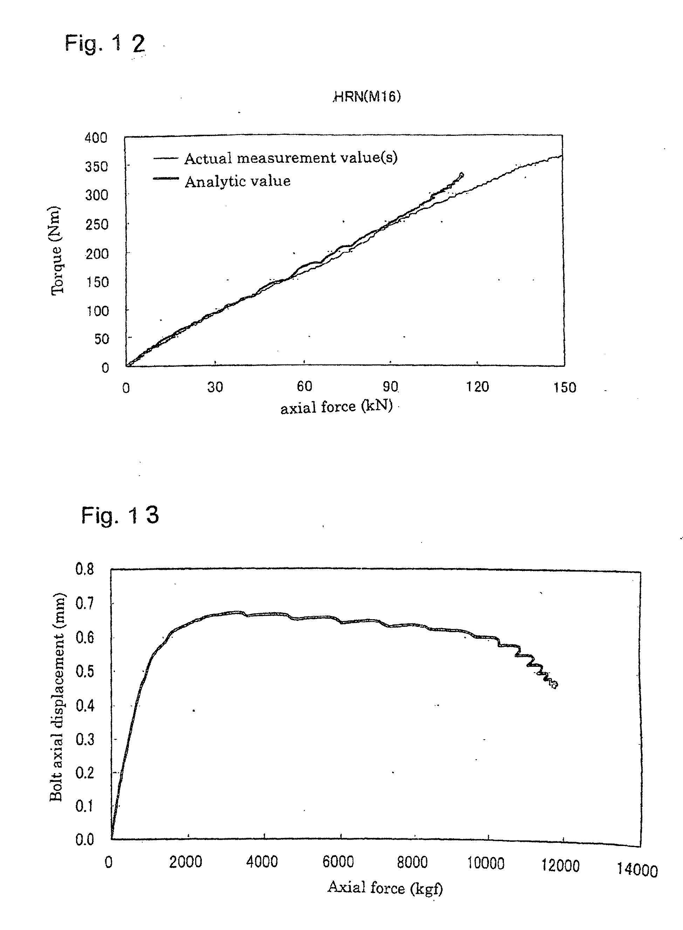

Here, FIG. 12 graphs comparison of analytical results on relation between axial force and the fastening torque with the actual measurement results. Axial force matches well each other in the value of the both results across the entire area to sufficiently show reliability of the analytical results thereof.

FIG. 13 graphs the amount of displacement of width in the elongated slit 3 of the nut body 1 from the axial centre of the bolt 5. The horizontal axis represents axial force and the vertical axis represents the amount of displacement in the axial centre of the bolt 5 respectively. And as axial force of the bolt 5 increases, the axial centre of the bolt 5 is displaced uniformly to reach around 0.65 mm. Thereafter, that displacement is kept as axial force increases and the displacement gets smaller from around 10000 kgf of axial force so that restoration is attained to reach around 0.45 mm approximately at 12000 kgf. The phenomenon that displacement of the axial centre of the bolt 5 gets smaller when axial force increases is that, as axial force increases, the slit width is deformed to decrease bolt displacement.

Subsequently, as a fastening structure in the nut body 1, the position of that elongated slit 3 and fastening effects were reviewed. That is, the force with narrow width of the elongated slit 3 is generated by axial force allocated to mating screw thread above the elongated slit 3 among the mating screw thread in the nut body 1 transmitting the axial force of the bolt 5 to the nut body 1.

In the case where the elongated slit 3 is provided in the upper portion of the nut body 1, the assigned axial force got smaller. In the case where the elongated slit 3 comes to the lower portion, the force with the narrowed elongated slit 3 increased. Consequently, since force retaining interference of pitches is strong, fastening effects are large.

Moreover, the nut body 1 is provided with right-angle elongated slit 3 and fastening narrows the elongated slit 3. Thereby the fastened bolt 5 is bent in the position of the elongated slit 3. Dynamics on rigidity of the bolt 5, that is, a decrease in width of the elongated slit 3 accompanies bending of the bolt. In addition, the bolt 5 is put under restraint by screw binding of the nut body 1 with the upper and the lower portions of the elongated slit 3. Under that condition, the decrease in width of the elongated slit 3 appears as interference level between the male thread and the female thread. That interference level will perform looseness prevention.

In addition, in that nut body 1, the bolt 5 and the nut body 1 include looseness prevention structure and a drop prevention mechanism in their structure. That is, in that embodiment, in the bolt 5 and in the nut body 1, the two surfaces of the fastening seating surface and the joint surface between the male screw and the female screw are in looseness prevention structure. Fastening ability is obtained by multiplying the frictional force between the two surfaces with the radius of the frictional centre. A bolt 5 with a large frictional coefficient, a bolt 5 with large nut body 1 and large seating surface radius and the nut body 1 hardly get loose.

In particular, the looseness prevention mechanism of that nut body 1 with the elongated slit 3 is interference by narrowing the female screw pitch. The female screw in the portion above the elongated slit 3 is attracted to the portion under the elongated slit 3 by an increase in the fastening axial force and the elongated slit 3 gets narrower. Thereby, the pitch of the nut body 1 gets narrower only in the position of the elongated slit 3.

The pitch gets narrowed with small axial force in the case of wide width of the elongated slit 3. However, narrowness of the pitch does not have to get larger than 1 pitch. In addition, a wide elongated slit 3 with smaller number of fitting threads is not preferable for structuring the nut body 1.

So far, the present invention can provide a nut requiring no complicated fastening procedure and no tools but capable of performing sufficient looseness prevention function.

## Claims

1. A nut provided with fastening structure in a nut body including a female screw dug concentrically along a vertical centre axis wherein an elongated slit is formed above a horizontal centre axis of the nut body and from one side thereof to a position beyond a vertical centre axis of the female screw toward the direction of the other side.

2. The nut apparatus comprising fastening structure according to claim 1, wherein the bottom of the nut body is an inclined plane making an inclined angle of around 1° to 5° against the horizontal plane.

3. The nut apparatus comprising fastening structure according to claims 1 and 2, wherein the inclined plane is higher in the direction of inclination thereof on an open end side of the elongated slit provided in the nut body.

4. The nut apparatus comprising fastening structure according to claims 1 to 3, wherein the inclined plane is higher in the direction of inclination thereof on a closed end side of the elongated slit provided in the nut body.

5. The nut apparatus comprising fastening structure according to claims 1 and 4, wherein height of the nut body establishes relation of (height of normal nut)×0.8=(height of nut body) compared with height of a normal nut currently on the market.
